# EUROPEAN PATENT APPLICATION

(11) **EP 4 614 186 A2**
(43) Date of publication of application: **10.09.2025**
(21) Application number: 25160186.0
(22) Date of filing: 26.02.2025
(51) Int. Cl.: G01S 7/521

(54) **SENSOR APPARATUS**

(30) Priority: 08.03.2024 KR 20240033477
(71) Applicant: Autonics Corporation, Busan 48002 (KR)
(72) Inventor: KIM, Myung Ho, 01913 Seoul (KR); PARK, Sa Hyun, 14915 Siheung-si, Gyeonggi-do (KR)
(74) Representative: Frenkel, Matthias Alexander

(57) **Abstract**

A sensor apparatus (1) according to an embodiment of the present invention for achieving the above-mentioned purpose comprises: an oscillator (22) configured to generate and transmit signals for detection; a main board (34) electrically connected to the oscillator (22), and on which is mounted a control chip for interpreting and processing signals transmitted by the oscillator (22); a cover (21) housing the oscillator; a case (31) housing the main board and having an end to which the cover is inserted and coupled; a shield body (351) enclosing at least a portion of the main board, to shield noise introduction; and a waterproof cushion (352) interposed between a rear end of the cover and a front end of the shield body (351).

## Description

### CROSS-REFERENCE TO RELATED APPLICATIONS

The present application claims the benefits of priority to Korean Patent Application No. 10-2024-0033477, filed on March 08, 2024, of which its incorporated herein by reference in its entirety.

### The background

### 1.The field

The present invention relates to a sensor apparatus.

### 2. Description of the related art

As an example of a sensor apparatus, an ultrasonic sensor is a sensor that generates a sound with a high frequency of about 20 kHz or higher and measures the time difference between the sound reflected from an object and the sound returning to the object to indicate the distance or the presence of an obstacle, and is applied to various systems such as a distance measurement system, an obstacle detection system, a snowfall detection system, etc.

These ultrasonic sensors have a structure that generates ultrasonic waves by applying a voltage to an oscillator (transducer) and receives sound waves reflected back from an object to generate a voltage.

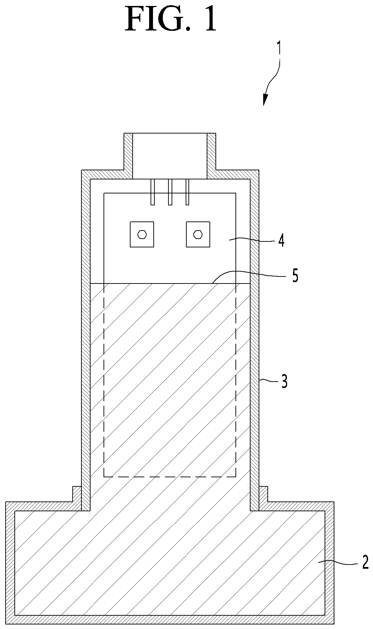

FIG. 1 is a cross-sectional view of a conventional ultrasonic sensor.

Referring to FIG. 1, a conventional ultrasonic sensor 1 includes a housing 3, an oscillator 2 housed inside the housing 3, a substrate 4, and a filler 5 made of an epoxy material filled inside the housing 3.

As shown, after mounting the oscillator 2 and the substrate 4 inside the housing 3, an epoxy material filler is filled inside the housing 3 to make it waterproof/dustproof and to prevent rotation of the substrate 4. In this case, the filler is filled to a height that submerges not only the oscillator 2 but also more than half of the substrate 4.

When the filler 5 envelops the substrate 4, a separate UV-coating is required on the substrate 4 to prevent damage or defect of the electric elements mounted on the substrate 4 due to shrinkage and/or expansion of the filler material.

Furthermore, even if there is no UV-coating inside, there is a disadvantage that the design of the separate filling structure is restricted in terms of design.

In addition, since the filling material is made of a structure that wraps around the circuit board and the housing is made of a single unit, it is not possible to disassemble the circuit board when a problem happens, and the sensor itself must be disposed of.

In addition, as a method for shielding inverter noise generated by the oscillator 2 from entering the substrate 4, a thin sheet of copper material is conventionally wrapped around the oscillator 2 and connected to the oscillator 2 or the substrate 4 by soldering.

In such a noise shielding structure, the bottom end of the noise shielding sheet wrapped around the substrate 4 is still open, so that inverter noise from the oscillator 2 enters the substrate 4 through the open bottom end.

### The summary

The present invention is proposed to improve the above problems.

A sensor apparatus according to an embodiment of the present invention for achieving the above-mentioned purpose comprises: an oscillator configured to generate and transmit signals for detection; a main board electrically connected to the oscillator, and on which is mounted a control chip for interpreting and processing signals transmitted by the oscillator; a cover housing the oscillator; a case housing the main board and having an end to which the cover is inserted and coupled; a shield body enclosing at least a portion of the main board, to shield noise introduction; and a waterproof cushion interposed between a rear end of the cover and a front end of the shield body.

The sensor apparatus according to an embodiment of the present invention further comprises a shield supporter provided at a rear end of the shield body to prevent the rear end of the shield body and the case from directly contacting each other.

The sensor apparatus according to an embodiment of the present invention further comprises a shield tape enclosing an outer circumferential surface of the shield body to prevent an outer circumferential surface of the shield body and an inner circumferential surface of the case from directly contacting each other.

The shield tape is formed in a size to cover an outer circumferential surface of the shield supporter.

The shield tape is formed in a size to cover at least a portion of an outer circumferential surface of the waterproof cushion.

The cover includes: a cover body having a cylindrical shape to house the oscillator therein; a seating jaw extending radially and inwardly from a front end of the cover body; and a watertight sleeve bending axially and rearwardly of the cover body at an end of the seating jaw, wherein a front edge of the oscillator is placed on the seating jaw, and the watertight sleeve is in close contact with the front edge of the oscillator.

The oscillator includes an outer case formed in a conductive material, and wherein a rear surface of the outer case is in contact with a front surface of the shield body.

The sensor apparatus according to an embodiment of the present invention further comprises a connect plug inserted into a rear side of the case, wherein the connect plug includes: a plug body having a cylindrical shape including a front edge from which a plurality of terminal bosses extend, and an opened rear edge; a plurality of seating ribs extending from the front edge of the plug body, and spaced apart circumferentially of the plug body; snagging hooks extending from the front edge of the plug body and disposed between the plurality of adjacent seating ribs.

The snagging hooks are provided in pairs and formed at points opposite to each other.

An inner circumferential surface of the case is formed with a hook groove in which the snagging hooks are hooked.

The plurality of seating ribs include first and second seating ribs extending in a position opposite to each other, and having different lengths, wherein at a rear end of the main board protrudes a seating jaw on which the first and second seating ribs are seated, wherein the seating jaw includes first and second seating jaws having different protruding lengths.

The longer length of the first and second seating ribs is seated on the shorter length of the first and second seating jaws, and wherein the shorter length of the first and second seating ribs is seated on the longer length of the first and second seating jaws.

The case includes: a lower housing accommodating at least a portion of the main board; an upper housing accommodating a remaining portion of the main board; and a coupler inserted into a rear end of the lower housing and a front end of the upper housing, wherein an inner circumferential surface of the coupler is formed with substrate guide grooves to guide insertion of the main board.

The substrate guide grooves are formed at points opposite to each other on the inner circumferential surface of the coupler.

The sensor apparatus according to an embodiment of the present invention having the above configuration has the following effects.

First, there is no need for silicone filling inside the housing for waterproofing and dustproofing, which has the advantage of improving productivity.

Second, the inner circumferential surface of the coupler is provided with a guide structure to guide the insertion of the circuit board, so that the circuit board is inserted in a fixed position and does not rotate due to external forces.

Third, a hook protrudes from the connect plug, and a hook groove is formed on the inner circumferential surface of the upper housing in which the hook protrudes, thereby preventing the main board from being pushed out due to excessive insertion of the connector plug when inserting the 5-pin cable.

Fourth, since the oscillator and the shielding member are in direct contact, and the ground wire extending from the oscillator is connected to the main board, there is no need to connect the shielding member and the main board for noise shielding.

### Brief description of the drawings

FIG. 1 is a cross-sectional view illustrating a conventional ultrasonic sensor.
FIG. 2 is a perspective view of a sensor apparatus according to an embodiment of the present invention.
FIG. 3 is an exploded perspective view of the sensor apparatus.
FIG. 4 is a longitudinal sectional view of the sensor apparatus with an incision along 4-4 of FIG. 2.
FIG. 5 is an enlarged view of portion A of FIG. 4.
FIG. 6 is an incised perspective view of a cover configuring the sensing module.
FIG. 7 is a longitudinal sectional view of a shielding member comprising a sensor apparatus according to an embodiment of the present invention.
FIG. 8 is a perspective view of a connect plug configuring a sensor apparatus according to an embodiment of the present invention.
FIG. 9 is a longitudinal perspective view of a connect plug with an incision along 9-9 of FIG. 8.
FIG. 10 is a cross-sectional view of a connect plug with incisions along 10-10 of FIG. 8.
FIG. 11 is a partially enlarged cross-sectional view showing the mating state of the connect plug and the main board.
FIG. 12 is a partially enlarged view of portion B of FIG. 4.
FIG. 13 is a perspective view of a coupler configuring a sensor apparatus according to an embodiment of the present invention.
FIG. 14 is a cross-sectional view of the coupler with an incision along 14-14 of FIG. 13.

### The detailed description

Hereinafter, a sensor apparatus according to an embodiment of the present invention will be described in detail with reference to the drawings.

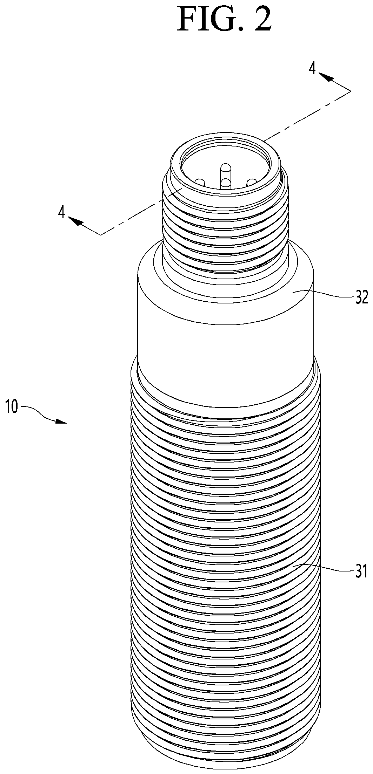

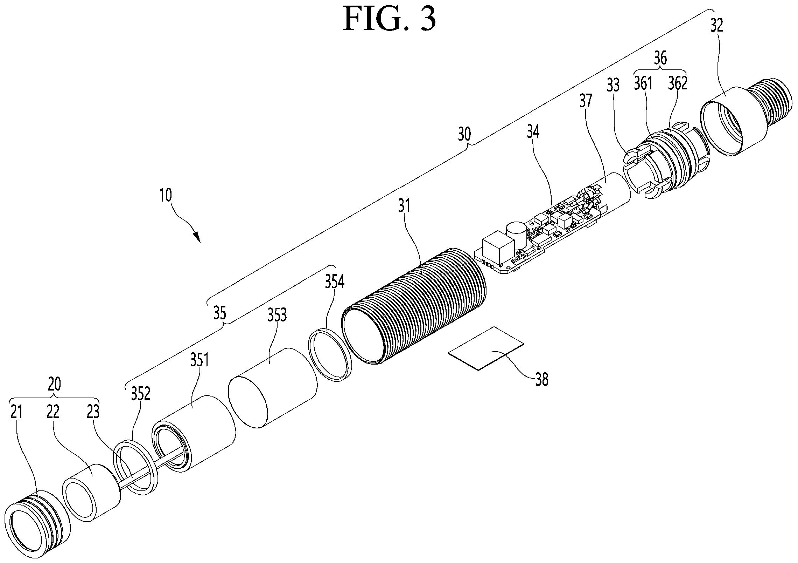

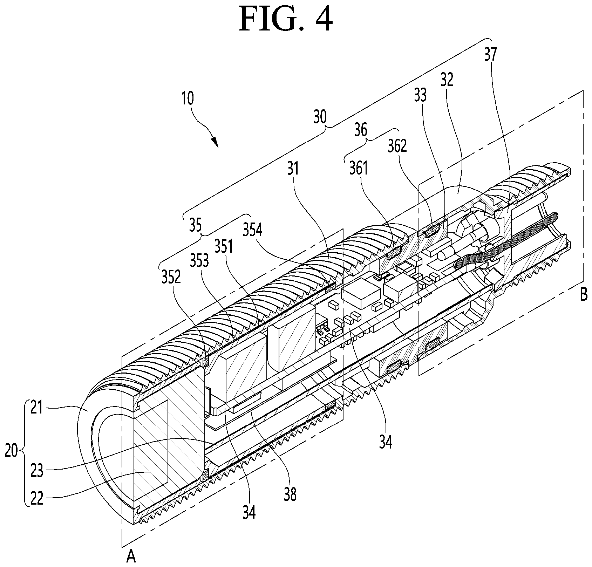

FIG. 2 is a perspective view of a sensor apparatus according to an embodiment of the present invention, FIG. 3 is a disassembled perspective view of the sensor apparatus, and FIG. 4 is a longitudinal sectional view of the sensor apparatus being cut along 4-4 of FIG. 1.

Referring to Figures 2 to 4, a sensor apparatus 10 according to an embodiment of the present invention can be described as comprising, in general, a sensing module 20 and a control module 30.

In detail, the sensing module 20 comprises an oscillator 22 generating ultrasonic waves, a cover 21 housing the oscillator 22, and a cable 23 extending from the oscillator 22. A signal wire and a ground wire are received inside the cable 23. Furthermore, the signal and ground wires are soldered to be coupled to a main board 34 to be described later.

In more detail, a front of the cover 21 is open so that a front of the oscillator 22 is exposed to an outside, so that the sensing signal generated by the oscillator 22 can be emitted to the outside, and the signal reflected back after hitting the target can be received.

Here, an ultrasonic sensor comprising an oscillator 22 generating ultrasonic waves is described as an example of the sensor apparatus 10, but it is to be understood that the ideas of the present invention are not to be construed as limited to the designation of the oscillator 22.

In other words, the oscillator 22 may comprise means other than an ultrasonic generator as a means of generating a signal for detection. For example, in the case of a capacitive proximity sensor, a capacitor electrode plate or a probe may be defined as an oscillator, and in the case of an infrared sensor, an infrared transmitter and receiver including an infrared emitting part and a receiving part may be defined as an oscillator.

Accordingly, it is to be understood that the oscillator 22 described herein is not limited to signal generating means that generate ultrasonic waves, but is to be defined and interpreted as a sensing signal transmitter and receiver that encompasses any signal transmitting and receiving means that generate and receive signals for sensing.

The control module 30 includes a lower housing 31, an upper housing 32, and a coupler 33 connecting the lower housing 31 and the upper housing 32. The combination or assembly of the lower housing 31, the upper housing 32 and the coupler 33 may be defined as a case forming the exterior of the control module 30. It is not excluded that the case is made of a cylindrical monolith, in addition to the structure comprising the lower housing 31, the upper housing 32 and the coupler 33.

The control module (30) may further comprise a seal ring 36 mounted on an outer circumferential surface of the coupler 33. The seal ring 36 may comprise a lower seal ring 361 that is in close contact with an inner circumferential surface of the lower housing 31 and an upper seal ring 362 that is in close contact with an inner circumferential surface of the upper housing 32.

Further, the control module 30 may further comprise a main board 34 inserted into the interior of the case, a connect plug 37 coupled to a top of the main board 34, and a shielding member 35 enclosing at least a portion of the main board 34 to shield noise.

A plurality of electrical components may be mounted on the front (or top) surface of the main board 34. The plurality of electronic components may include one or more light emitting elements, a control chip for interpreting and processing signals transmitted by the oscillator 22, and the like.

The shielding member 35 is provided for shielding inductive noise penetrating into the main board 34 from the outside of the sensor apparatus 10. In detail, the shielding member 35 comprises a shield body 351 of cylindrical shape made of a conductive material, a waterproof cushion 352 coupled to one end of the shield body 351, a shield supporter 354 coupled to the other end of the shield body 351, and a shield tape 353 enclosing the outer circumferential surface of the shield body 351.

The waterproof cushion 352 may include a rubber ring provided for dust and water proofing purposes, the waterproof cushion 352 being pressed against the rear end of the cover 21 to prevent moisture from penetrating between the outer circumferential surface of the cover 21 and the inner circumferential surface of the lower housing 31 and entering the main board 34.

The shield tape 353 is provided to prevent the inner circumferential surface of the lower housing 31 and the outer circumferential surface of the shield body 351 from being in direct contact and causing a short circuit.

The shield supporter 354 is provided to prevent the other end of the shield body 351 and the lower housing 31 from being in direct contact and causing a short circuit.

Meanwhile, the control module 30 may further comprise an auxiliary seat 38 which is provided at the rear of the main board 34 to protect circuit components mounted on the main board 34.

Meanwhile, the coupler 33 may comprise a transparent or translucent plastic material, such that light emitted from the light emitting element including the LED mounted on the main mode 34 may pass through the coupler 33 and be recognized by the user's eyes.

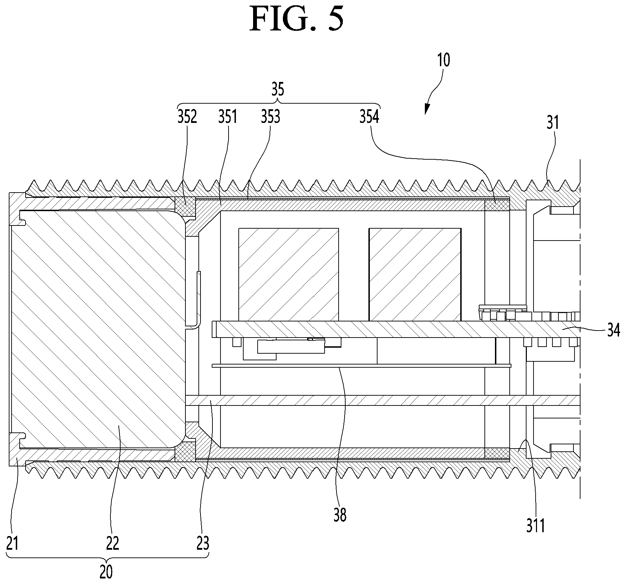

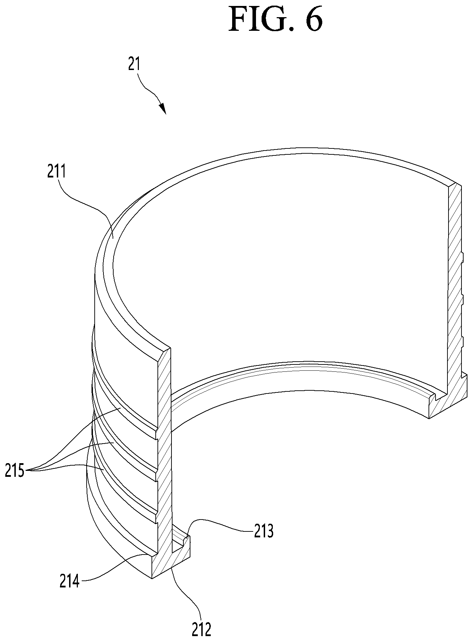

FIG. 5 is an enlarged view of part A of FIG. 4, and FIG. 6 is an incised perspective view of the cover configuring the sensing module.

Referring to FIGs. 5 and 6, the sensor apparatus 10 according to an embodiment of the present invention is characterized in that the interior of the lower housing 31 is not filled with epoxy resin for moisture and dust protection, but is provided with other forms of moisture and dust protection.

As a means to this end, first, the structure of the cover 21 housing the oscillator 22 is improved.

In detail, the cover 21 provided for the sensor apparatus 10 according to an embodiment of the present invention comprises a cover body 211 having a cylindrical shape, and a housing seating jaw 214 projecting radially outwardly from a first (front) end of the cover body 211, an oscillator seating jaw 212 projecting radially and inwardly from the first end of the cover body 211, a watertight sleeve 213 projecting parallel to the cover body 211 at an end of the oscillator seating jaw 212, and a plurality of watertight ribs 215 surrounding an outer circumferential surface of the cover body 211.

The inner diameter of the cover body 211 is formed in a size corresponding to the outer diameter of the oscillator 22, so that the inner circumferential surface of the cover body 211 is in close contact with the outer circumferential surface of the oscillator 22.

Furthermore, when the cover 21 is inserted into the first end of the lower housing 31, the end of the lower housing 31 is in close contact with the housing seating jaw 214 to fix the position, and moisture penetration is firstly prevented.

Furthermore, when the cover 21 is inserted into the lower housing 31, the plurality of watertight ribs 215 are strongly pressed against the inner circumferential surface of the lower housing 31, thereby again blocking the penetration of moisture into the gap between the cover 21 and the lower housing 31. Furthermore, the friction or adhesion force between the plurality of watertight ribs 215 and the lower housing 31 prevents the cover 21 from being pushed forward of the lower housing 31 and being pulled out.

Furthermore, when the oscillator 22 is inserted inside the cover body 211, the watertight sleeve 213 is strongly pressed against the front edge of the oscillator 22, thereby preventing moisture from penetrating between the cover body 211 and the oscillator 22.

The oscillator 22 comprises an outer case made of a conductive material including a metal, a piezo arranged inside the outer case to generate ultrasonic vibrations, and a polyurethane foam filled in the outer case to enclose the piezo. In detail, the outer case is in the form of a U-shape with an opening at the front, the interior of which is filled with the polyurethane. It is to be appreciated that the material filled inside the outer casing may be any other type of material, including polyurethane.

When the oscillator 22 is inserted inside the cover 21, the watertight sleeve 213 presses against the front of the oscillator 22. Then a portion of a front portion of the oscillator 22 in contact with the watertight sleeve 213 is depressed and surround the watertight sleeve 213, thereby preventing moisture from penetrating into the contact portion of the cover 21 and the oscillator 22.

On the other hand, on the inner circumferential surface of the lower housing 31, a snagging jaw 311 protrudes, which sets the insertion limit of the shielding member 35, thus preventing the shielding member 35 from being pushed and over-inserted into the lower housing 31.

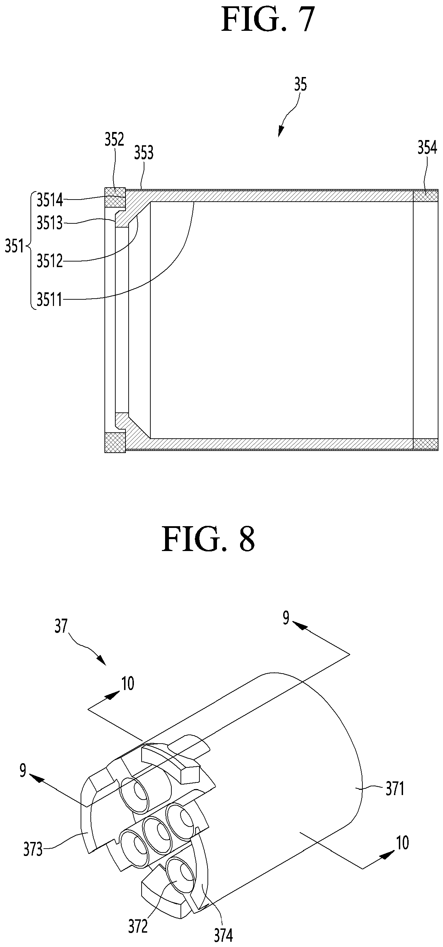

FIG. 7 is a longitudinal sectional view of a shielding member constituting a sensor apparatus according to an embodiment of the present invention.

Referring to FIG. 7, the shielding member 35 configuring the sensor apparatus 10 is characterized in that, as described above, the shield body 351 of a cylindrical shape surrounds at least a portion of the main board 34 to block noise from penetrating into the main board 34 through the lower housing 31.

In detail, the shield body 351 comprises a cylindrical portion 3511, a seating jaw 3514 formed at one end (front) of the cylindrical portion 3511, and a contact sleeve 3513 extending axially of the cylindrical portion 3511 from an inner edge of the seating jaw 3514.

The waterproof cushion 352 is seated on the seating jaw 3514 and fits tightly against the outer edge of the oscillator 22, thereby secondarily preventing moisture introduced from the cover 21 and the oscillator 22 from penetrating into the interior of the shielding member 35.

Furthermore, the contact sleeve 3513 is in contact with the rear end of the outer case configuring the oscillator 22, and the rear end of the shielding member 35 is caught by the snagging jaw 311, thus preventing the oscillator 22 from being pushed rearwardly. Then, the cable 23 extending from the oscillator 22 is soldered to the main board 34. With this structure, noise penetrating through the oscillator 22 flows directly through the case of the oscillator 22 and through the shield body 351, thus there is an advantage that the shield body 351 and the main board 34 do not need to be connected by a ground wire.

On the other hand, a tapered portion 3512 is formed on an inner circumferential surface of one end of the cylindrical portion 3511 and connects an inner end of the cylindrical portion 3511 with an inner end of the contact sleeve 3513.

Furthermore, at the other (rear) end of the cylindrical part 3511, the shield supporter 354 in the shape of a ring is coupled, which prevents the rear end of the shield body 351 from directly contacting the snagging jaw 311 of the lower housing 31, thereby preventing a short circuit from occurring.

Further, the shield tape 353 is a tape of insulating material, which prevents the outer circumferential surface of the shield body 351 from directly contacting the inner circumferential surface of the lower housing 31 and causing the short circuit.

Then, the shield tape 353 is formed in a length that completely wraps around the outer circumferential surface of the shield body 351 and the shield supporter 354, such that the rear end of the shield tape 353 and the rear end of the shield supporter 354 coincide. This has the advantage of eliminating the need for connecting means for connecting the shield body 351 and the shield supporter 354.

Furthermore, the shield tape 353 may be provided in a size that only partially wraps around the outer circumferential surface of the waterproof cushion 352. More specifically, since the waterproof cushion 352 may be pressed and compressed during assembling process, wrinkles may occur in the shield tape 353 if the shield tape 353 wraps all of the waterproof cushion 352. Therefore, only a portion of the waterproof cushion 352 may be enclosed by the shield tape 353.

Alternatively, the shield tape 353 may be constructed such that the shield tape 353 does not cover the waterproof cushion 352, i.e., the length of the shield tape 353 may be set such that the front end of the shield tape 353 coincides with the front end of the shield body 351.

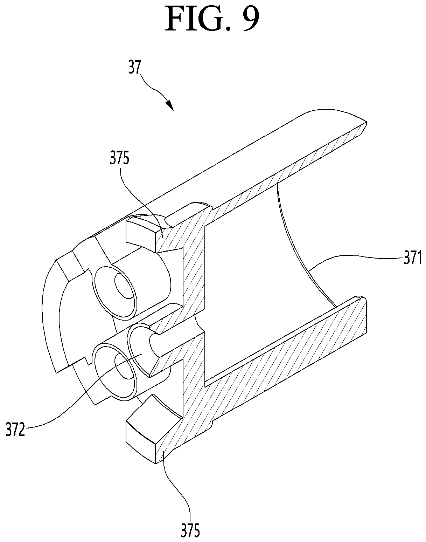

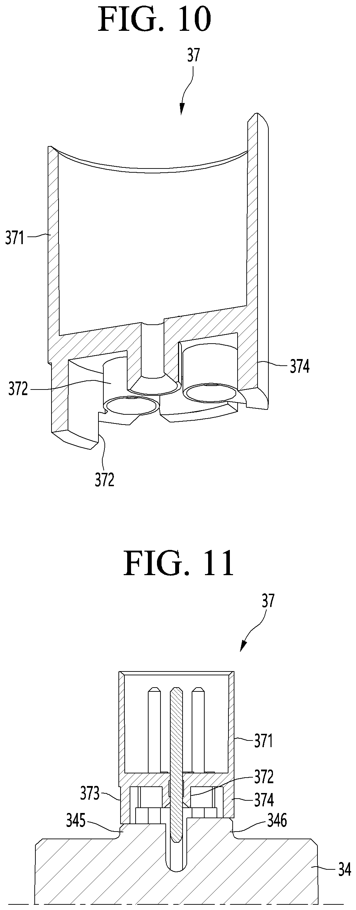

FIG. 8 is a perspective view of a connect plug configuring a sensor apparatus according to an embodiment of the present invention, FIG. 9 is a longitudinal view of the connect plug through an incision along 9-9 of FIG. 8, and FIG. 10 is a cross-sectional view of the connect plug through an incision along 10-10 of FIG. 8.

Referring to FIGs. 8 to 10, a connect plug 37 configuring the sensor apparatus 10 according to an embodiment of the present invention comprises a plug body 371 having a cylindrical shape with a sealed front surface(or bottom surface) and an open rear surface (or top surface), a plurality of terminal bosses 372 extending from the front surface, a seating rib extending from an edge of the front surface, and a hanging hook 375 extending from an edge of the front surface.

The seating rib may include a first seating rib 373 and a second seating rib 374 formed opposite to the first seating rib 373. The first seating rib 373 and the second seating rib 374 may extend to different lengths, for example, the first seating rib 373 may be formed longer than the second seating rib 374.

The hanging hook 375 may comprise a pair of hooks provided opposite to each other. The pair of hooks may extend between adjacent seating ribs.

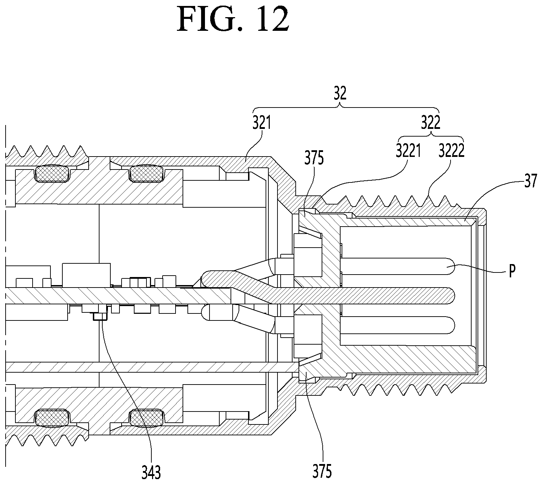

The terminal bosses 372 may be provided in a number corresponding to the number of terminals or pins P (see FIG. 12) being soldered to the main board 34, the terminals or pins P are soldered to the main board 34 by passing through the terminal bosses 372.

FIG. 11 is a partially enlarged cross-sectional view showing the mating state of the connect plug and the main board.

Referring to FIG. 11, a rear end (or upper end) of the main board 34 may have a seating jaw protruding therefrom to contact the seating rib. The seating jaws may include a first seating jaw 345 in contact with the first seating rib 373, and a second seating jaw 346 in contact with the second seating rib 374. Furthermore, the height of the first seating jaw 345 may be less than the height of the second seating jaw 346.

According to this structure, if the connect plug 37 is incorrectly inserted in a direction where the second seating rib 374 faces the first seating rib 345 faces the first seating jaw 345, and the first seating rib 373 faces the second seating jaw 346, the mating of the connect plug 37 is prevented, so that the user can recognize the misassembling.

FIG. 12 is an enlarged view of portion B of FIG. 4.

Referring to FIG. 12, the upper housing 32 includes a housing body 321 and a housing neck 322 extending from a rear end of the housing body 321.

More specifically, the housing neck 322 extends with a diameter smaller than the diameter of the housing body 321, and the connect plug 37 is inserted into the interior of the housing neck 322. To the inside of the housing body 321 is coupled an upper hook 333 of the coupler 33.

Furthermore, a hook groove 3221 is formed on the inner circumferential surface of the housing neck 322 and a thread 3222 is formed on the outer circumferential surface of the housing neck 322. When the connect plug 37 is inserted into the interior of the housing neck 322, the hanging hook 375 of the connect plug 37 hooks into the hook groove 3221. Then, when a cable is inserted and engaged to the rear end of the connect plug 37, it has the advantage that even if an excessive insertion force is applied to the connect plug 37, the main board 34 is not pushed forward.

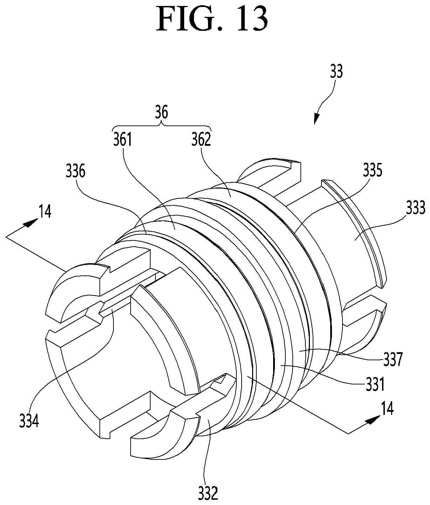

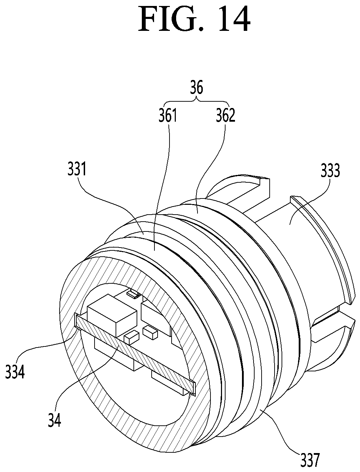

Figure 13 is a perspective view of a coupler configuring a sensor apparatus according to an embodiment of the present invention, and FIG. 14 is a cross-sectional view of the coupler being cut along 14-14 of FIG. 13.

Referring to FIGs. 13 and 14, a coupler 33 configuring a sensor apparatus according to an embodiment of the present invention includes a coupler body 331 having a cylindrical shape, a plurality of hanging hooks 332 extending from a front end (or bottom end) of the coupler body 331, a separation rib 337 projecting from an outer circumferential surface of the coupler body 331, and a substrate guide groove 334 recessed in an inner circumferential surface of the coupler body 331. The substrate guide groove 334 may extend from one end (front end) to the other end (rear end) of the coupler body 331.

Further, the rear end of the lower housing 31 is in close contact with the front surface of the separation rib 337, and the front end of the upper housing 32 is in close contact with the rear of the separation rib 337, such that the upper surface of the separation rib 337 is exposed to the outside. By this structure, the light irradiated from the light emitting element mounted on the main board 34 is emitted to the outside through the separation rib 337 and becomes recognizable to the user's eye.

In detail, since the coupler 33 is made of a material through which light can pass, and since the separation rib 337 is surrounded by a circular band shape on the outer peripheral surface of the coupler body 331, light emitted from the light-emitting element 343 is emitted to the outside through the entire upper surface of the circular separation rib 337. Thus, the separation rib 337 can be recognized as light surrounded by a circular band on the outer peripheral surface of the sensor apparatus 10.

In detail, the separation rib 337 may be formed at a position spaced apart from the front and rear ends of the coupler body 331, respectively. For example, the separation rib 337 may be located at a position spaced an equal distance apart from the front and rear ends of the coupler body 331, but are not limited thereto.

On the outer circumferential surface of the coupler body 331 corresponding to an area between the separation rib 337 and the front end of the coupler body 331, a lower sealing groove 336 is formed into which the lower seal 361 is fitted. On the outer circumferential surface of the coupler body 331 corresponding an area between the separation rib 337 and the rear end of the coupler body 331, an upper sealing groove 335 is formed into which the upper sealing 362 is fitted.

Meanwhile, the substrate guide grooves 334 are respectively formed on the inner circumferential surface of the coupler body 331 at positions opposite to each other. In the pair of substrate guide grooves 334, two side ends of the main board 34 are inserted, thereby guiding the main board 34 to be inserted smoothly into the lower housing 31 and preventing the main board 34 from rotating about the center axis of the lower housing 31 and upper housing 32.

## Claims

1. A sensor apparatus, comprising:
an oscillator, configured to generate and transmit signals for detection;
a main board electrically connected to the oscillator, and on which is mounted a control chip for interpreting and processing signals transmitted by the oscillator;
a cover housing the oscillator;
a case housing the main board and having an end to which the cover is inserted and coupled;
a shield body enclosing at least a portion of the main board, to shield noise introduction; and
a waterproof cushion interposed between a rear end of the cover and a front end of the shield body.

2. The sensor apparatus according to claim 1, further comprising a shield supporter provided at a rear end of the shield body to prevent the rear end of the shield body and the case from directly contacting each other.

3. The sensor apparatus according to claim 1 or 2, further comprising a shield tape enclosing an outer circumferential surface of the shield body to prevent an outer circumferential surface of the shield body and an inner circumferential surface of the case from directly contacting each other.

4. The sensor apparatus according to claim 3, wherein the shield tape is formed in a size to cover an outer circumferential surface of the shield supporter.

5. The sensor apparatus according to claim 3 or 4, wherein the shield tape is formed in a size to cover at least a portion of an outer circumferential surface of the waterproof cushion.

6. The sensor apparatus according to any one of claims 1 to 5, wherein the cover includes:
a cover body having a cylindrical shape to house the oscillator therein;
a seating jaw extending radially and inwardly from a front end of the cover body; and
a watertight sleeve bending axially and rearwardly of the cover body at an end of the seating jaw,
wherein a front edge of the oscillator is placed on the seating jaw,
and the watertight sleeve is in close contact with the front edge of the oscillator.

7. The sensor apparatus according to any one of claims 1 to 6, wherein the oscillator includes an outer case formed in a conductive material,
and wherein a rear surface of the outer case is in contact with a front surface of the shield body.

8. The sensor apparatus according to any one of claims 1 to 7, further comprising a connect plug inserted into a rear side of the case,
wherein the connect plug includes:
a plug body having a cylindrical shape including a front edge from which a plurality of terminal bosses extend, and an opened rear edge;
a plurality of seating ribs extending from the front edge of the plug body, and spaced apart circumferentially of the plug body;
snagging hooks extending from the front edge of the plug body and disposed between the plurality of adjacent seating ribs.

9. The sensor apparatus according to claim 8, wherein the snagging hooks are provided in pairs and formed at points opposite to each other.

10. The sensor apparatus according to claim 8 or 9, wherein an inner circumferential surface of the case is formed with a hook groove in which the snagging hooks are hooked.

11. The sensor apparatus according to any one of claims 8 to 10, wherein the plurality of seating ribs include first and second seating ribs extending in a position opposite to each other, and having different lengths,
wherein at a rear end of the main board protrudes a seating jaw on which the first and second seating ribs are seated,
wherein the seating jaw includes first and second seating jaws having different protruding lengths.

12. The sensor apparatus according to claim 11, wherein the longer length of the first and second seating ribs is seated on the shorter length of the first and second seating jaws,
and wherein the shorter length of the first and second seating ribs is seated on the longer length of the first and second seating jaws.

13. The sensor apparatus according to any one of claims 1 to 12, wherein the case includes:
a lower housing accommodating at least a portion of the main board;
an upper housing accommodating a remaining portion of the main board; and
a coupler inserted into a rear end of the lower housing and a front end of the upper housing,
wherein an inner circumferential surface of the coupler is formed with substrate guide grooves to guide insertion of the main board.

14. The sensor apparatus according to claim 13, wherein the substrate guide grooves are formed at points opposite to each other on the inner circumferential surface of the coupler.
